# EUROPEAN PATENT SPECIFICATION

(11) **EP 1 427 077 B1**
(45) Date of publication and mention of the grant of the patent: **18.04.2007**
(21) Application number: 03253417.4
(22) Date of filing: 30.05.2003
(51) Int. Cl.: H01S 5/14

(54) **External cavity laser having improved single mode operation**
Laser mit externem Resonator und verbessertem Einzelmodenbetrieb
Laser à cavité externe avec un fonctionnement monomode amelioré

(30) Priority: 02.12.2002 US 308541; 08.04.2003 US 409879
(43) Date of publication of application: 09.06.2004
(73) Proprietor: Newport Corporation, Irvine, CA 92606 (US)
(72) Inventor: Rella, Chris, Sunnyvale, CA 94085 (US); Koulikov, Serguei, Sunnyvale, CA 94085 (US); Paldus, Barbara, Sunnyvale, CA 94085 (US); Pakulski, Grzegorz, Sunnyvale, CA 94085 (US); Crosson, Eric, Sunnyvale, CA 94085 (US)
(74) Representative: Benson, John Everett

(56) References cited:
- US-A- 6 018 536
- US-A1- 2002 136 104
- US-A1- 2002 163 942
- US-B1- 6 282 215

## Description

### Field of the Invention:

This invention relates to lasers, and more specifically to lasers which operate stably in a single mode.

### Background:

A laser consists of a pumped gain element positioned within an optical resonator. The pumped gain element provides light amplification, and the optical resonator provides optical feedback, such that light circulates within the optical resonator along a round trip beam path and is repeatedly amplified by the gain element. The optical resonator (also referred to as the laser cavity) may be either a ring cavity or a standing-wave cavity. The laser cavity defines a set of longitudinal cavity modes, evenly spaced by a wavelength interval referred to as the laser cavity free spectral range (FSR). The cavity free spectral range depends on the optical length (i.e., physical length times index of refraction) of the round trip path within the cavity. More generally, the free spectral range of an etalon (i.e., an optical resonator formed by two reflective surfaces) is the wavelength separation between two adjacent transmission peaks. Laser emission generally occurs at one or more of the cavity mode wavelengths. Optical pumping and electrical pumping by current injection are two known methods for pumping the gain element.

One of the elements within the optical resonator acts as the output coupler, whereby a certain fraction of the circulating light is emitted from the optical resonator to provide the useful laser output. The emitted light may or may not be in the visible part of the electromagnetic spectrum. A partially transmitting mirror is a known output coupler. For semiconductor lasers, the output coupler is typically an end face of a semiconductor gain element, which may be coated to provide a degree of reflectivity which optimizes performance. Semiconductor gain media typically include an epitaxially grown multilayer structure, and are classified according to the propagation direction of the emitted light. A gain element is a surface emitter if the emitted light propagates perpendicular to the plane of the layers. A gain element is an edge emitter if the emitted light propagates in the plane of the layers. Edge emitting semiconductor gain media typically include a single mode optical waveguide.

In some laser applications, the laser is required to emit radiation at a specific wavelength (e.g., 976.0 nm). Since semiconductor gain elements typically provide significant gain over a wide range of wavelengths (e.g., a range greater than 10 nm), the gain element by itself typically does not select the laser emission wavelength with sufficient accuracy for such applications. Insertion of an optical bandpass filter into the laser cavity is one method for selecting the laser emission wavelength. A bandpass filter has relatively low loss in a narrow wavelength band (centered at a center wavelength λ_{c}), and relatively high loss for all other wavelengths with significant gain. Since the laser emission wavelength is normally at or near the wavelength at which the net gain (i.e., gain - loss) is maximal, a bandpass filter is a suitable wavelength selective element, provided the variation of filter loss with wavelength is greater than the variation of gain with wavelength. One approach for making a bandpass filter is to construct an interference filter, which includes multiple layers of low loss optical materials, where the interference between reflections from multiple interfaces within the structure can provide a variety of filter responses (including a bandpass response). Methods for designing and fabricating interference filters to achieve various desired filtering specifications are known in the art.

In order to select a specific emission wavelength of a laser, it is sometimes desirable to employ an external cavity geometry, where the laser cavity includes one or more optical elements which are spaced apart from the gain element. The use of an external cavity for a semiconductor laser allows the use of wavelength selective elements which are difficult to fabricate in a monolithic semiconductor structure. For semiconductor lasers, the flexibility provided by an external cavity configuration generally provides improved optical performance (e.g., improved emission wavelength accuracy and/or an increased side mode suppression ratio) relative to a monolithic semiconductor laser.

In many laser applications, it is desirable to ensure monomode operation, where the laser output is essentially at a single wavelength, so that the output power and/or wavelength remain substantially fixed for an extended period of time. The side mode suppression ratio (SMSR) is a measure of the degree of monomode operation provided by a laser. The SMSR is the ratio of the power in the lasing mode to the maximum power in any non-lasing mode. A free running laser operating in a single mode will tend to occasionally "hop" from one cavity mode to another cavity mode, and such mode hops cause undesirable changes in output wavelength and/or output power. Therefore, the mode hop rate is another measure of the degree of monomode operation provided by a laser. Although requirements on SMSR and mode hop rate for a monomode laser are significantly application-dependent, many applications require high SMSR (e.g., greater than 30 dB) and low mode hop rate (e.g., preferably less than once per minute, more preferably less than once per hour). Some applications require substantially complete elimination of mode hops.

Laser stabilization is typically provided by an appropriate control system. One known approach is to measure the output power and/or wavelength of a laser to derive control signals that are used to alter laser parameters to cause the output power and/or wavelength to maintain desired fixed values. For example, the output power and wavelength of an electrically pumped semiconductor laser depend on the laser temperature and the pump current, so these two parameters can be controlled to maintain the power and wavelength at fixed values. However, it is difficult for such a control system to effectively suppress mode hops, since monitoring only the laser output does not provide information that clearly "warns" the control system of an impending mode hop so that it can be avoided.

US 2002/0163942 relates to a monomode external cavity laser and its mode of operation. The laser comprises a semi-conductor gain element, a single reflectivity band reflector acting as wavelength selective element. Light reflected from the wavelength selective element propagates on a round trip path in the cavity. Light transmitted through the wavelength selective element is detected. A processing logic derives a control signal from the electrical signal of the detector.

### Summary of the Invention:

According to the present invention, stable single mode operation of an external cavity semiconductor laser is obtained by a laser control method that monitors at least one optical beam which is generated by reflection from a wavelength selective element within the laser cavity. The method of the present invention provides stable single mode operation and significantly suppresses mode hops, because the signal obtained by reflection from a wavelength selective element within the laser cavity provides a clear indication (or warning) of an impending mode hop.

According to the invention there is provided a method for emitting a monomode optical beam from an external cavity laser comprising an optical resonator having a round trip path, the method comprising:
a) amplifying light traveling on said round trip path by passing said light through a pumped semiconductor gain element (12);
b) transmitting light traveling on said round trip path through an etalon or other wavelength selective element (12) which is spaced apart from said gain element (12);
c) reflecting a portion of light traveling on said round trip path from said wavelength selective element (18), wherein said reflected portion follows a path which is distinct from said round trip path;
d) detecting a fraction of said reflected portion of light to provide an electrical signal;
e) deriving a control signal from said electrical signal; and
f) controlling a parameter of said laser responsive to said control signal to provide monomode operation of said laser,
wherein said parameter is controlled substantially to hold said control signal fixed at a predetermined non-minimal value, whereby said reflected portion of light has non-minimal power.

According to a further aspect of the invention there is provided an external cavity laser comprising an optical resonator having a round trip path, wherein the resonator comprises:
a) a pumped semiconductor gain element (12); and
b) an etalon or other wavelength selective element (18) spaced apart from said gain element, wherein a portion of light traveling on said round trip path is reflected from said wavelength selective element and wherein said reflected portion follows a path which is distinct from said round trip path;
and wherein the laser further comprises:
c) a first detector (22) which receives a fraction of said reflected portion of light and provides an electrical signal in response to said reflected portion; and
d) processing logic to derive a control signal from said electric signal; wherein a parameter of said laser is controlled by said processing logic in response to said control signal to provide monomode operation of said laser and said parameter is controlled substantially to hold said control signal fixed at a predetermined noun-minimal value whereby said reflected portion of light has non-minimal power.

### Brief Description of the Drawings:

Figure 1 shows the intracavity optical elements of an embodiment of the invention in a schematic top view.
Figure 1b schematically shows a preferred embodiment of the invention.
Figure 2 is a plot of control signals measured from an embodiment of the invention.
Figure 3 is a plot of measured hysteresis from an embodiment of the invention.
Figure 4 schematically shows a second embodiment of the invention.

### Detailed Description of the Drawings:

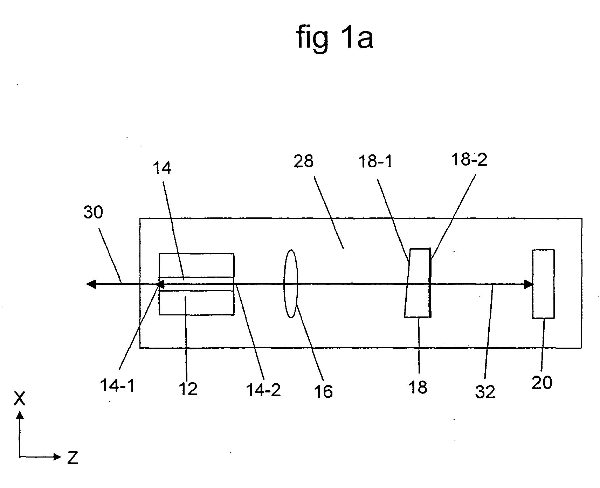

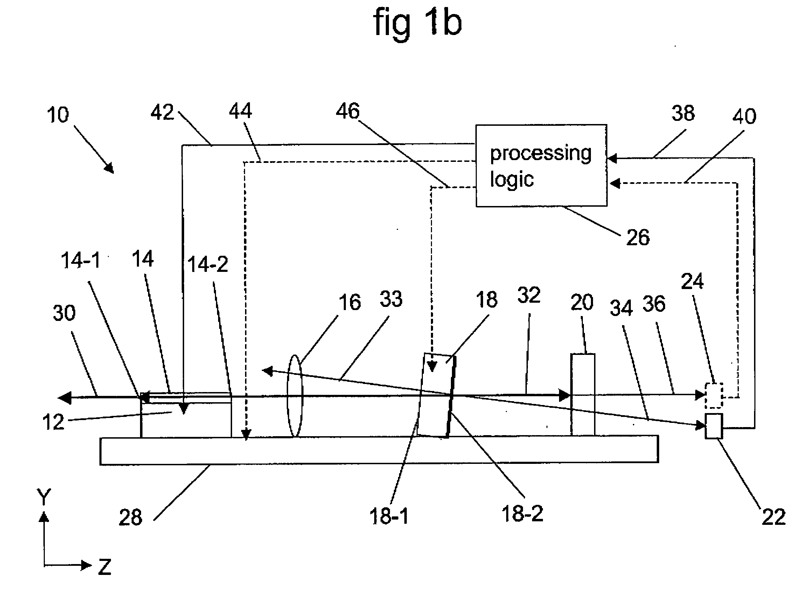

Figures 1a and 1b, taken together, show a preferred embodiment of the invention. Figure 1b schematically shows an external cavity semiconductor laser 10 according to the present invention, including a side view of the intracavity elements of this embodiment. Figure 1a shows a schematic top view of these intracavity elements.

It is convenient to start the discussion at output face 14-1 of semiconductor gain element 12 on figure 1a and follow a round trip within the laser cavity. Output face 14-1 is preferably coated to provide a low level of reflectivity which optimizes laser output power. Typical reflectivities for output face 14-1 are approximately in the range of 0.5 to 10 percent. Gain element 12 is preferably an electrically pumped semiconductor single or multiple quantum well structure which contains a single mode optical waveguide 14. The light reflected from output face 14-1 propagates through waveguide 14 of gain element 12 and is emitted from internal face 14-2 of gain element 12. Internal face 14-2 is typically anti-reflection (AR) coated to reduce the effect of the etalon formed by faces 14-1 and 14-2. Typical reflectivities for internal face 14-2 are approximately in the range of 0.05 to 1 percent. In addition, the axis of waveguide 14 can be configured to intersect internal face 14-2 at an acute angle, which also tends to reduce the effect of the etalon formed by faces 14-1 and 14-2. The gain element etalon has a free spectral range (FSR) which depends on the optical length between faces 14-1 and 14-2 of gain element 12. A suitable gain element 12 is a JDSU 6560 chip (having horizontal full-width half-maximum (FWHM) beam divergence of about 8.85 degrees, vertical FWHM beam divergence of about 20.5 degrees, and a gain element FSR of about 16.7 GHz). The invention can, of course, be practiced with other gain elements.

Optical radiation is emitted from internal face 14-2 of gain element 12 as a diverging beam which is received and collimated by lens 16. Lens 16 is preferably AR coated on both surfaces, with a reflectivity of preferably less than 0.5 percent on each surface. A suitable lens is Geltech model 350140, which is an aspheric lens with 1.45 mm focal length and a numerical aperture of 0.55, but other lenses with different focal lengths and/or numerical apertures can also be employed to practice the invention. The collimated beam propagates from lens 16 to wavelength selective element 18.

Wavelength selective element 18 is preferably a bandpass interference filter having a transmission FWHM of about 0.1 nm centered on a center wavelength λ_{c}. Filters with bandwidths in the range of about 0.05 to 2 nm are also suitable for practicing the invention. The transmission loss at λ_{c} is preferably less than 50 percent, and is more preferably less than 10 percent. The transmission loss at wavelengths which are amplified by gain element 12 but are well outside the filter bandwidth (i.e., separated in wavelength from λ_{c} by several times the FWHM) is preferably greater than 90 per cent. Methods for fabricating interference filters to achieve these specifications are known in the art. Wavelength selective element 18 typically includes a substrate with two surfaces 18-1 and 18-2. The above bandpass interference filter is typically deposited as a multilayer coating on either surface 18-1 or surface 18-2 of wavelength selective element 18. The other surface of wavelength selective element 18 is typically AR coated to provide a reflectivity of preferably less than 0.1 percent. The substrate of wavelength selective element 18 provides mechanical support for the filter coating. Since wavelength selective element 18 introduces a relatively low loss for λ_{c} and relatively high loss for all other wavelengths which are amplified by gain element 12, laser 10 emits radiation having a wavelength that is at or near (i.e., within about a cavity FSR of) the center wavelength λ_{c}. The choice of λ_{c} is application dependent. Wavelength selective element 18 preferably has a narrow bandwidth (e.g., 0.1 nm in this case), to suppress laser emission at cavity modes which are adjacent in wavelength to the lasing mode. Although the filter specifications and configuration given above are suitable for practicing the invention, other wavelength selective elements having different specifications and/or configurations can also be used to practice the invention.

Wavelength selective element 18 is preferably tilted with respect to the axis of cavity round trip path 32, so that reflections from its surfaces are not coupled into waveguide 14 of gain element 12. A tilt of 4.25 degrees has been found suitable, although the invention may be practiced with other tilts. Since the center wavelength λ_{c} of a bandpass filter typically depends on the angle of incidence of an optical beam on the filter, the tilt angle must be included in the specification of λ_{c} (e.g., λ_{c} = 976.0 nm for a 4.25 degree angle of incidence).

The beam emitted from wavelength selective element 18 is received by, and reflected from, return mirror 20. Return mirror 20 is preferably a plane mirror with a high reflectivity (i.e., reflectivity > 90 percent) coating on its front surface. Return mirror 20 preferably has a large enough clear aperture so that the beam received by mirror 20 is not clipped at the edges. For a Gaussian beam with 1/e amplitude radius w at the position of return mirror 20, preferred clear apertures have a diameter greater than 4w to ensure negligible clipping. In some cases, a Gaussian beam received by return mirror 20 does not have a circular cross section, and in these cases, the 4w criterion for preferred clear apertures is applied using the larger of wₕ and wᵥ, where wₕ and wᵥ are the horizontal and vertical 1/e Gaussian beam radii, respectively, at the position of return mirror 20. Return mirrors other than the preferred mirror described above can also be used to practice the invention.

The beam reflected from mirror 20 propagates back though wavelength selective element 18, lens 16, and waveguide 14 of gain element 12 in succession to complete a cavity round trip. Cavity round trip path 32 is shown on figures 1a and 1b. A fraction of light incident on end face 14-1 from within waveguide 14 is emitted as output beam 30. Gain element 12, lens 16, wavelength selective element 18 and mirror 20 are preferably affixed to a monolithic support means 28 (optional), commonly referred to as a bench, to provide mechanical stability for the laser, using mounting hardware and methods which are not shown or discussed, since suitable hardware and methods are known in the art. Bench 28 is preferably made from a material such as aluminum nitride which provides high stiffness and low thermal expansion. Other bench materials and configurations may also be used to practice the invention. For example, instead of the flat bench shown on figure 1b, a cylindrical bench can be used. Alternatively, the invention may be practiced without the use of bench 28.

Having discussed the elements encountered in the course of a cavity round trip with reference to figure 1a, we now consider figure 1b, which shows these intracavity elements in a schematic side view, as well as additional elements which together comprise a monomode external cavity laser 10.

In cases where wavelength selective element 18 is tilted, it is preferable to choose the orientation of this tilt so that beam 33 reflected from surface 18-2 of wavelength selective element 18 toward gain element 12 does not impinge on gain element 12, as shown on figure 1b. This preferred tilt orientation eliminates the possibility of reflected beam 33 causing damage to gain element 12. A portion of the light traveling on round trip path 32 is reflected from surface 18-2 of wavelength selective element 18 toward mirror 20, and a fraction of this reflected beam is transmitted through mirror 20 as beam 34 which is received by detector 22. A portion of the light traveling on round trip path 32 is also transmitted through mirror 20 as beam 36. Due to the tilt of wavelength selective element 18, beam 34 follows a path that differs from cavity round trip path 32, which ensures spatial separation of beam 34 from beam 36, as shown on figure 1b. Detector 22 is positioned to receive beam 34, but not beam 36.

Wavelength selective element 18 is preferably wedged, to reduce the effect of the etalon formed by surfaces 18-1 and 18-2. A 0.2 degree wedge is suitable, but other wedge angles may also be used to practice the invention. A suitable orientation of this wedge is shown on figure 1a. The amount of light reflected from surface 18-1 of wavelength selective element 18 that is received by detector 22 is preferably negligible. This condition can be provided by AR coating of surface 18-1 and/or by choosing a wedge angle between surfaces 18-1 and 18-2 such that the beam reflected from surface 18-1 misses detector 22. If the reflectivity of surface 18-1 is sufficiently low (i.e., its reflectivity is less than about 0.1 percent), then it is not necessary to make the reflection from surface 18-1 miss detector 22 (by choosing a sufficiently large wedge angle for surface 18-1 and 18-2).

Although figures 1a and 1b show an embodiment where the bandpass filter is deposited on surface 18-2 and an AR coating is deposited on surface 18-1 of wavelength selective element 18, the invention can also be practiced with the roles of surfaces 18-1 and 18-2 reversed. .

Since light reflected from surface 18-2 of wavelength selective element 18 is transmitted through mirror 20 to be received by detector 22, mirror 20 preferably has a low absorbance (i.e., less than 0.5 percent), where the absorbance is the fraction of incident light that is neither reflected nor transmitted. Mirror 20 need not provide low absorbance in cases where beams reflected from wavelength selective element 18 do not impinge on mirror 20.

Detector 22 (e.g., a photodetector) receives optical beam 34 and provides electrical signal 38 to processing logic 26. The transmittance of mirror 20 is preferably chosen to ensure that electrical signal 38 is substantially proportional to the intensity of beam 34 (i.e., the optical power incident on detector 22 is low enough to ensure negligible detector saturation). Electrical signal 38 is a direct measure of the loss introduced in the laser by wavelength selective element 18. For example, if the laser emission wavelength drifts relative to the center wavelength of wavelength selective element 18 (or vice versa), electrical signal 38 will increase or decrease depending on the separation between the laser emission wavelength and the filter center wavelength. As this wavelength separation increases, the loss introduced by wavelength selective element 18 increases, thus increasing electrical signal 38. As this separation increases further, the laser will eventually hop to a mode at a new wavelength which is closer to the filter center wavelength, since the round trip loss at the new wavelength will be reduced. Thus, an increase in electrical signal 38 provides a clear indication of an impending mode hop, so this signal is suitable for use in a control system designed to reduce the mode hop rate.

Processing logic 26 implements a control method to ensure monomode operation based on electrical signal 38. The following discussion will focus on various control methods, since implementation of such methods (in processing logic 26) in hardware and/or in software is known in the art. Processing logic 26 receives electrical signal 38, and preferably controls the current supplied to gain element 12 via control output 42. Optionally, processing logic 26 may also receive electrical signal 40, and/or may control the temperature of gain element 12 via control output 42, and/or may control the temperature of bench 28 via control output 44, and/or may control the optical length of wavelength selective element 18 via control output 46. The various parameters which may be controlled by processing logic 26 are discussed below.

There are various control methods based on electrical signal 38 which can be implemented by processing logic 26 to reduce the mode hop rate. Such a method can be regarded as the combination of three elements: 1) a method for deriving a control signal from electrical signal 38; 2) the identification of one or more laser parameters which affect the control signal (i.e., how far the laser is from a mode hop); and 3) a control algorithm which specifies the condition on the control signal (e.g., minimization of the control signal) to be achieved by varying the laser parameter(s). Since there are various options for each of these three elements, we consider each element individually.

One approach for deriving a control signal from electrical signal 38 is to equate the control signal to electrical signal 38. An alternative approach is to derive a control signal from electrical signal 38 that does not change when the laser output (or circulating) power changes. One way to provide this normalization is shown on figure 1b, where a fraction of light traveling on round trip path 32 is emitted from mirror 20 as reference beam 36, which is received by detector 24. Detector 24 provides electrical signal 40 to processing logic 26. A control signal equal to the ratio of electrical signal 38 to electrical signal 40 does not change as the laser power changes. For this reason, such a normalized control signal is preferable to a control signal based on signal 38 alone, although either approach may be used to practice the invention. It is also possible to employ other methods for deriving a suitable control signal. For example, if stray light impinges on detector 22, the control signal can be derived from electrical signal 38 by subtracting an empirically determined background level from electrical signal 38. Similarly, if detector 24 is present, and stray light impinges on it, the control signal can be derived by calculating the ratio of a corrected electrical signal 38 (with detector 22 background subtracted out) to a corrected electrical signal 40 (with detector 24 background subtracted out).

Suitable laser control parameters include any parameter that affects the round trip optical path length within the laser resonator. Variation of such a parameter will change the wavelength separation between the laser emission wavelength and the center wavelength of wavelength selective element 18, since varying the round trip path length changes the wavelength of each cavity mode (including the lasing mode). Therefore, suitable control parameters include, but are not limited to, the following: the temperature of any element within the laser; the temperature of any element which establishes the round trip path length (e.g., bench 28); the current supplied to gain element 12, if it is electrically pumped; the optical power supplied to gain element 12 if it is optically pumped; or a signal provided to a phase adjustment element within the laser cavity. The temperature of bench 28 and the temperature of gain element 12 can be independently controlled if a second thermoelectric cooler (TEC) is positioned between gain element 12 and bench 28 (in addition to a first TEC positioned beneath bench 28). A phase adjustment element, if present, may be integrated with gain element 12 (e.g., in a similar manner as phase control sections for distributed Bragg reflector lasers), or it may be combined with wavelength selective element 18 (e.g., a wavelength selective element 18 that includes an electro-optic substrate), or it may be a separate element within the optical resonator. For an electrically pumped gain element 12, it is preferable to use the laser current as the control parameter.

Various algorithms can be implemented for adjusting the control parameter responsive to the measured control signal. One algorithm is to adjust the control parameter to minimize the control signal. Methods for minimizing a signal responsive to variation of a parameter are known in the art. This algorithm ensures that the laser emission wavelength is a wavelength of minimum loss induced by wavelength selective element 18. Since all other cavity modes have a higher round trip loss, this algorithm is suitable for decreasing the mode hop rate in cases where gain element 12 does not affect the mode selection process. A second algorithm is to adjust the control parameter to maintain the control signal below a predetermined threshold. Methods for maintaining a signal below a threshold value by variation of a parameter that affects the signal are known in the art. This second algorithm is also suitable for decreasing the mode hop rate in cases where gain element 12 does not affect the mode selection process.

However, we have found that gain element 12 sometimes affects the mode selection process. This interaction between gain element 12 and the laser emission wavelength is manifested in two ways: 1) the laser exhibits significant hysteresis in the output power vs. pumping level curve (usually called the "LI curve") as the pumping level is increased and then decreased; and 2) stable monomode laser operation is not necessarily obtained when the laser emission wavelength is a wavelength of minimum loss induced by wavelength selective element 18. In lasers which manifest either or both of these features, the preferred control algorithm is to maintain the control signal fixed at a predetermined (typically non-minimal) value by varying the control parameter.

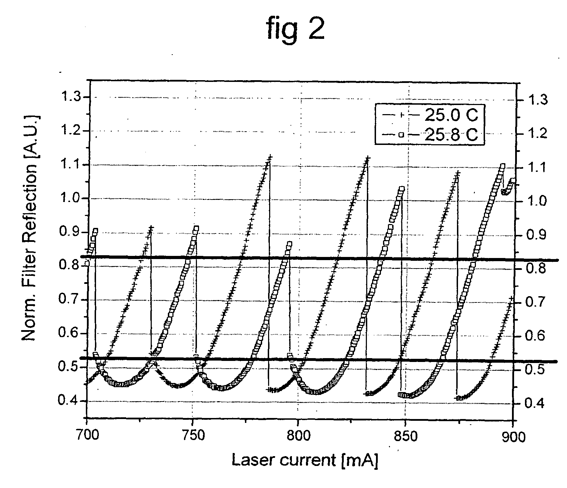

Figure 2 shows how such a value for the control signal can be determined. This figure shows a plot of the measured normalized reflection (in arbitrary units) from wavelength selective element 18 (i.e., a control signal equal to the ratio of electrical signal 38 to electrical signal 40) at two slightly different temperatures (crosses 25.0 C and squares 25.8 C) versus the current supplied to gain element 12 (i.e., the control parameter). The data in figure 2 is obtained from an embodiment of the invention as shown in figures 1a and 1b. On figure 2, sharp vertical transitions in the measured signals are due to mode hops, and the regions between these transitions provide monomode operation. The curves on figure 2 show that minimizing the control signal is an inappropriate control algorithm for this laser, since mode hops occur at or near the points of minimum control signal. The preferred control algorithm for this laser is to maintain the control signal at about a value of 0.67 (which is roughly the midpoint between the two heavy dotted lines on figure 2) by varying the current supplied to gain element 12. Since the heavy dotted lines on figure 2 are drawn to enclose a range of control signal values corresponding to monomode operation, controlling the current to center the control signal within this range (i.e., by maintaining the control signal at about 0.67) is an effective method for reducing the mode hop rate. Although the specific numerical values obtained in this example may to vary as the details of the laser change, and/or as the calculation of the control signal is varied, this measurement procedure can be used to determine such values for other lasers and/or other methods of calculating the control signal.

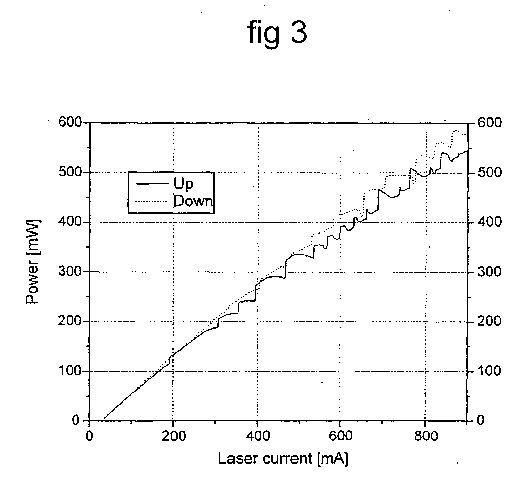

As indicated above, the interaction between gain element 12 and laser emission wavelength also tends to induce hysteresis in the LI curve, as shown on figure 3. The solid line on figure 3 is a measured LI curve obtained when the current is scanned from a low value to a high value, while the dotted line on figure 3 is a measured LI curve from the same laser obtained by scanning the current from a high value to a low value. To provide consistent laser operation in the presence of this hysteresis, it is frequently preferred to approach a desired operating point "from above". For example, suppose it is desired to operate the laser at 700 mA current. A preferred way of setting the current to 700 mA (from a value that is lower than 700 mA) is to first set the current to a value that is substantially higher than 700 mA (e.g., 750 to 850 mA), then monotonically decrease the current from this higher value to 700 mA. Thus the operating point of 700 mA is approached from above. The control signal curves shown in figure 2 are consistent with this approach for dealing with hysteresis, since they were taken by scanning the current from the high end of the current scale to the low end of the current scale.

Summarizing the above discussion, a preferred control method to ensure monomode operation of an external cavity laser 10 includes the following three elements: 1) a preferred control signal, which is derived from the ratio of electrical signal 38 to electrical signal 40; 2) a preferred control parameter, which is the current supplied to gain element 12, and 3) a preferred control algorithm, which is to maintain the control signal at a predetermined value. This predetermined value for the control signal is preferably chosen by making measurements as indicated in the discussion of figure 2, and then choosing a value that is roughly centered in the range of monomode operation.

In cases where multiple monomode external cavity lasers are manufactured using nominally identical parts and procedures, the measurements used to determine a suitable predetermined control signal level need not be done individually on each laser. Instead, a predetermined control signal level suitable for all of these nominally identical lasers can be derived from measurements of a sample set of lasers using known statistical sampling techniques.

In the embodiment of figures 1a and 1b, it is preferred that the free spectral range (FSR) of the etalon formed by faces 14-1 and 14-2 of gain element 12 be approximately an integer multiple of the cavity FSR. This matching of the gain element FSR to the cavity FSR provides improved laser operation, as taught in copending, commonly assigned, US patent application 10/327,576, filed Dec. 20, 2002, entitled "Laser with reduced parasitic etalon effect".

In the above discussion of the embodiment of figures 1a and 1b, a preferred wavelength selective element 18 is a fixed wavelength (i.e., non-tunable) bandpass interference filter. Since single mode control of a tunable (i.e., variable wavelength) laser is similar to single mode control of a fixed wavelength laser, the invention can also be practiced using a tunable wavelength selective element 18. Suitable tuning elements for use in such embodiments include, but are not limited to, mechanically rotatable filters or etalons and electrically tunable filters or etalons. Suitable electrically tunable filters or etalons include etalons with an electrically adjustable physical separation between the mirrors (e.g., an etalon where the mirror separation is varied electrostatically), and etalons with an electrically adjustable optical length between the mirrors (e.g., an etalon where the mirrors are separated by an electro-optical material such as a ferroelectric crystal or a liquid crystal).

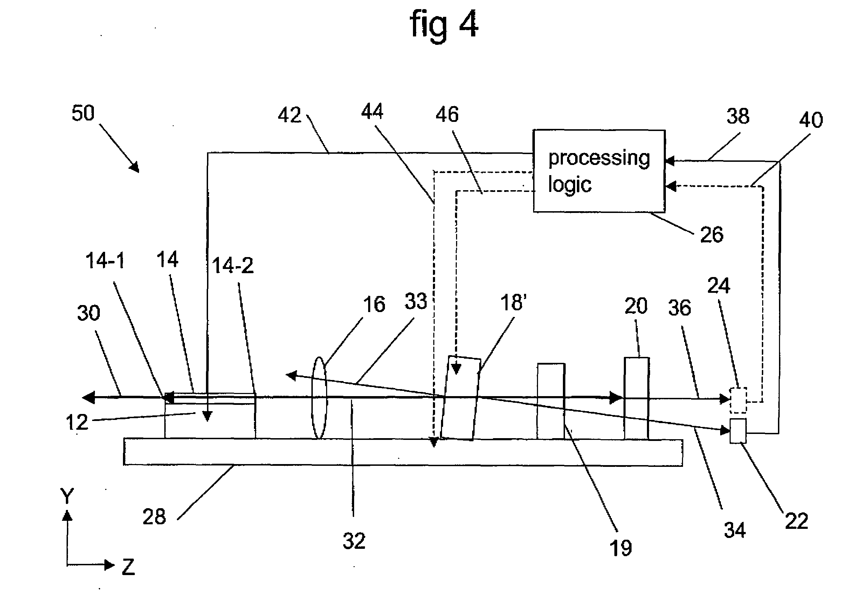

Figure 4 schematically shows a second embodiment of the invention. Monomode external cavity laser 50 shown on figure 4 is the same as laser 10 shown on figure 1b except for the substitution of wavelength selective element 18' on figure 4 for wavelength selective element 18 on figure 1b, and the addition of filter 19 on figure 4 to laser 50. Functionally, filter 19 on figure 4 selects the emission wavelength of laser 50, while wavelength selective element 18' suppresses laser emission at cavity modes adjacent to the laser emission wavelength, thus improving monomode performance. In other words, the functions of wavelength selection and adjacent cavity mode suppression performed by wavelength selective element 18 on figure 1b are performed by two separate elements (i.e., elements 18' and 19) in the embodiment of figure 4. Since this additional element (i.e., element 19) makes the embodiment of figure 4 more complex than the embodiment of figure 1b, the embodiment of figure 4 is most suitable in cases where it is difficult (or impossible) to obtain a required level of monomode laser performance with a single optical element (i.e., 18 on figure 1b) that both selects the wavelength and suppresses adjacent cavity modes.

Filter 19 on figure 4 is preferably a bandpass filter with a center wavelength λ_{c} that is application dependent. The preceding discussion of a preferred wavelength selective element 18 on figure 1a (which was a bandpass filter) is also applicable to filter 19 on figure 4, except that the bandwidth of filter 19 need not be as narrow as the preferred bandwidth of wavelength selective element 18. The reason for this reduced requirement on the bandwidth of filter 19 is that another element (i.e., wavelength selective element 18' on figure 4) also acts to suppress adjacent cavity modes in the embodiment of figure 4. In some cases, the functions of filter 19 and mirror 20 can be combined in a single optical element (e.g., an embodiment where a diffraction grating provides retro reflection only for a narrow wavelength range).

A suitable wavelength selective element 18' satisfies the following three requirements: 1) wavelength selective element 18' has a transmission peak (referred to as peak A) at or near the center wavelength λ_{c} of filter 19; 2) the bandwidth of peak A is substantially less than the bandwidth of filter 19; and 3) wavelength selective element 18' introduces relatively high loss at all wavelengths that are not within peak A, but are near the transmission peak of filter 19. In other words, wavelength selective element 18' selects a single wavelength within the bandwidth of filter 19. Since a preferred approach for meeting these three requirements is to fabricate wavelength selective element 18' as a mode suppressing etalon, the term "etalon 18''' is used as an abbreviation for "a mode suppressing etalon which is a preferred wavelength selective element 18' on figure 4" in the following two paragraphs.

As indicated above, etalon 18' preferably has a transmission peak bandwidth that is substantially less than the bandwidth of filter 19, so that etalon 18' provides significant suppression of adjacent cavity modes in addition to the suppression provided by filter 19. Methods for aligning a transmission peak (i.e., peak A) of etalon 18' with the center wavelength λ_{c} of filter 19, such as adjusting the angle between round trip path 32 and the surfaces of etalon 18', are known in the art. The FSR of etalon 18' is preferably at least about equal to the bandwidth of filter 19, which ensures a significant difference between the loss at the wavelength of peak A (at λ_{c}) and the loss at a wavelength of an adjacent transmission peak of etalon 18'. Etalon 18' in figure 4 is preferably inserted into the laser cavity such that it is tilted (i.e., its surface normals make a small angle, preferably 0.1-2 degrees, with respect to round trip path 32), to thereby ensure that beams reflected from its surfaces do not efficiently couple into the laser cavity. The finesse of etalon 18' is preferably moderate (e.g., 2 < finesse < 10), and the finesse is chosen to provide low loss in transmission through the tilted etalon, and the desired level of spectral selectivity. Since this etalon serves as an absolute wavelength reference for the laser, it is preferably fabricated using a material, such as fused silica, that is mechanically stable and temperature insensitive. In addition, it is preferred that a longitudinal cavity mode (as defined by the laser resonator) wavelength be present at or near each transmission peak of etalon 18' that is within the wavelength adjustment range (i.e., the range of wavelengths within which the emission wavelength is selected by filter 19 when laser 50 is assembled). A preferred method for achieving this alignment of longitudinal modes to the transmission peaks of etalon 18' is to design the laser so that the FSR of etalon 18' is substantially an integer multiple of the cavity FSR, and one of the transmission peaks of the etalon 18' within the wavelength adjustment range is substantially aligned with a longitudinal mode defined by the laser resonator.

As shown on figure 4, the orientation of the tilt of etalon 18' is preferably chosen to ensure that beam 33 reflected from etalon 18' does not impinge on gain element 12. Beam 34 is received by detector 22 which provides electrical signal 38 in response. Since electrical signal 38 provides a direct measure of the loss introduced by etalon 18' at the lasing wavelength, it is suitable for use in a control system to reduce the mode hop rate, and the various control methods discussed in connection with figures 1b, 2 and 3 are also applicable to the embodiment of figure 4.

In the embodiment of figure 4, it is preferred that the free spectral range (FSR) of etalon 18' be approximately an integer multiple of the FSR of the etalon formed by faces 14-1 and 14-2 of gain element 12. This matching of the gain element FSR to the FSR of etalon 18' provides improved laser operation, as taught in copending, commonly assigned, US patent application 10/327,576, filed Dec. 20, 2002, entitled "Laser with reduced parasitic etalon effect".

In the above discussion of the embodiment of figure 4, a preferred filter 19 is a fixed wavelength (i.e., not tunable) bandpass interference filter. Since single mode control of a tunable laser is similar to single mode control of a fixed wavelength laser, the invention can also be practiced using a tunable filter 19. Suitable tuning elements for use in such embodiments include, but are not limited to, mechanically rotatable filters or etalons, or diffraction gratings and electrically tunable filters or etalons. Suitable electrically tunable filters (or etalons) include etalons with an electrically adjustable physical separation between the mirrors (e.g., an etalon where the mirror separation is varied electrostatically), etalons with an electrically adjustable optical length (i.e., length times index of refraction) between the mirrors (e.g., an etalon where the mirrors are separated by an electro-optical material such as a ferroelectric crystal or a liquid crystal), and acousto-optically tuned filters.

A common feature of the tunable and fixed wavelength embodiments of figures 1 b and 4 is a wavelength selective element (which is preferably a bandpass filter in the embodiment of figure 1b, and which is preferably a mode suppressing etalon in the embodiment of figure 4) positioned in the resonator such that a beam reflected from its surface follows a path which differs from the resonator round trip light path. The spatial separation of this reflected beam path from the round trip path allows a detector to be positioned to receive the reflected beam without substantially receiving other beams. The intensity of the reflected beam is a direct measure of the loss introduced by the wavelength selective element at the laser emission wavelength, which makes it a suitable signal for use in a control method designed to reduce the mode hop rate.

The control methods discussed above for providing monomode operation can be combined with other control methods (e.g., methods for ensuring constant output power). For example, if monomode operation is provided using the current to gain element 12 as a control input, the temperature of gain element 12 can be controlled in a second control loop to provide substantially constant output power. In cases where a second control loop is employed in addition to the monomode control loop, the two loops preferably have substantially different time constants, to reduce the interaction between the loops. In the above example, the power control loop will naturally tend to be slower than the monomode stabilization loop, since temperature change and output power drift both tend to be slow.

## Claims

1. A method for emitting a monomode optical beam from an external cavity laser comprising an optical resonator having a round trip path, the method comprising:
a) amplifying light traveling on said round trip path by passing said light through a pumped semiconductor gain element (12);
b) transmitting light traveling on said round trip path through an etalon or other wavelength selective element (12) which is spaced apart from said gain element(12);
c) reflecting a portion of light traveling on said round trip path from said wavelength selective element (18), wherein said reflected portion follows a path which is distinct from said round trip path;
d) detecting a fraction of said reflected portion of light to provide an electrical signal;
e) deriving a control signal from said electrical signal; and
f) controlling a parameter of said laser responsive to said control signal to provide monomode operation of said laser
wherein said parameter is controlled substantially to hold said control signal fixed at a predetermined non-minimal value, whereby said reflected portion of light has non-minimal power.

2. The method of claim 1, wherein said gain element (12) is selected from an electrically pumped gain element and an optically pumped gain element; and/or said gain element is selected from an edge emitting gain element and a surface emitting gain element.

3. The method of claim 1 or 2, wherein said wavelength selective element (18) has a fixed center wavelength or a tunable center wavelength.

4. The method of any preceding claim, wherein said wavelength selective element (18) comprises: a bandpass or other interference filter; or an etalon.

5. The method of any preceding claim, wherein said resonator has a resonator free spectral range determined by the optical length of said round trip path and said gain element has a gain element free spectral range determined by the optical length of said gain element and wherein said gain element free spectral range is substantially a whole number multiple of said resonator free spectral range.

6. The method of any preceding claim, wherein the step of deriving said control signal from said electrical signal comprises:
i) emitting a fraction of light traveling on said round trip path from said resonator to provide a reference beam;
ii) detecting a fraction of said reference beam to provide a reference signal; and
iii) deriving said control signal from said electrical signal and said reference signal.

7. The method of any preceding claim, wherein the step of deriving said control signal from said electrical signal comprises setting said control signal: substantially equal to a ratio of said electrical signal to said reference signal; or substantially equal to said electrical signal.

8. The method of any preceding claim, wherein said gain element (12) is electrically pumped, and said parameter comprises a current supplied to said gain element.

9. The method of any preceding claim, wherein said parameter comprises the temperature of said gain element (12), or a current supplied to an electrically driven phase adjuster.

10. The method of any preceding claim, wherein said laser further comprises i) a bench affixed to said gain element (12), and ii) a return mirror (20) affixed to the bench, the return mirror comprising one end of said resonator and the gain element comprising another end of said resonator, and wherein said parameter is the temperature of the bench.

11. The method of any preceding claim, further comprising:
g) selecting an operating pumping level supplied to said gain element (12);
h) setting a pumping level supplied to said gain element to a second level that is substantially greater than said operating pumping level; and
i) decreasing a pumping level supplied to said gain element from said second level to said operating pumping level.

12. The method of claim 1, further comprising controlling the temperature of said gain element (12) to ensure the power of said optical beam remains substantially equal to a predetermined value; and/or transmitting light traveling on said round trip path through a filter.

13. The method of claim 12, wherein said filter has a fixed center wavelength or a tunable center wavelength.

14. An external cavity laser comprising an optical resonator having a round trip path, wherein the resonator comprises:
a) a pumped semiconductor gain element (12); and
b) an etalon or other wavelength selective element (18) spaced apart from said gain element, wherein a portion of light traveling on said round trip path is reflected from said wavelength selective element and wherein said reflected portion follows a path which is distinct from said round trip path;
and wherein the laser further comprises:
c) a first detector (22) which receives a fraction of said reflected portion of light and provides an electrical signal in response to said reflected portion; and
d) processing logic to derive a control signal from said electric signal;
wherein a parameter of said laser is controlled by said processing logic in response to said control signal to provide monomode operation of said laser and said parameter is controlled substantially to hold said control signal fixed at a predetermined non-minimal value whereby said reflected portion of light has non-minimal power.

15. The laser according to claim 14, wherein said gain element (12) is selected from an electrically pumped gain element and an optically pumped gain element; and/or said gain element is selected from edge emitting gain element and a surface emitting gain element.

16. The laser according to claim 14, wherein said wavelength selective element (18) has a fixed center wavelength or a tunable center wavelength.

17. The laser according to claim 14, wherein said wavelength selective element (18) comprises: a bandpass or other interference filter; or an etalon.

18. The laser of any of claims 14 to 17, wherein said wavelength selective element (18) is an etalon and wherein said etalon has an etalon free spectral range determined by the optical length of said etalon, and said gain element has a gain element free spectral range determined by the optical length of said gain element, and wherein said etalon free spectral range is substantially a whole number multiple of said gain element free spectral range.

19. The laser of any of claims 14 to 18, further comprising a second detector positioned to receive a fraction of light traveling on said round trip path and provide a reference signal.

20. The laser of any of claims 14 to 19, wherein said control signal provided by said processing logic is substantially a ratio of said electrical signal to said reference signal, or is substantially equal to said electrical signal.

21. The laser of any of any of claims 14 to 20, wherein said gain element (12) is electrically pumped, and said parameter comprises a current supplied to said gain element.

22. The laser of any of claims 14 to 21, wherein said parameter comprises the temperature of said gain element (12) or a current supplied to an electrically driven phase adjuster.

23. The laser of any of claims 14 to 22, wherein said laser further comprises i) a bench affixed to said gain element (12), and ii) a return mirror affixed to the bench, the return mirror comprising one end of said resonator and the gain element comprising another end of said resonator, and wherein said parameter is the temperature of the bench.

24. The laser of any of claims 14 to 23, wherein said processing logic controls the temperature of said gain element (12) to ensure the power of said optical beam remains substantially equal to a predetermined value.

25. The laser of any of claims 14 to 24, further comprising a fixed center wavelength filter or a tunable center wavelength filter or other filter positioned within said resonator.

## Patentansprüche

1. Verfahren zum Emittieren eines einmodigen (monomode) optischen Strahls aus einem Laser mit externer Kavität und mit einem optischen Resonator mit umlaufendendem Strahlungsweg (Umlaufweg), wobei das Verfahren die folgenden Schritte umfasst:
a) Verstärken von Licht, welches auf dem umlaufenden Strahlungsweg verläuft, derart, dass es ein gepumptes Halbleiter-Verstärkungselement (12) durchläuft;
b) Führen des auf dem Umlaufweg verlaufenden Lichtes durch ein Etalon oder ein anderen wellenlängenselektives Element (12) unter Abstand vom genannten Verstärkungselement (12);
c) Reflexion eines Teils des auf dem Umlaufweg verlaufenden Lichts an dem genannten wellenlängenselektiven Element (18), wobei der genannte reflektierte Teil auf einem Strahlungsweg sich ausbreitet, der verschieden ist von dem genannten Umlaufweg;
d) Detektieren eines Bruchteils des genannten reflektierten Teils des Lichts, um ein elektrisches Signal zu gewinnen;
e) Ableiten eines Steuersignals aus dem genannten elektrischen Signal; und
f) Steuern eines Parameters des Lasers entsprechend dem genannten Steuersignal, um einen Monomode-Betrieb des Lasers zu erhalten,
wobei der genannte Parameter im wesentlichen so gesteuert wird, dass das genannte Steuersignal auf einem vorgegebenen, nicht-minimierten Wert gehalten wird, wodurch der genannte reflektierte Teil des Lichts eine nicht-minimierte Leistung hat.

2. Verfahren nach Anspruch 1, wobei das genannte Verstärkungselement (12) ausgewählt ist aus folgenden Möglichkeiten: einem elektrisch gepumpten Verstärkungselement und einem optische gepumpten Verstärkungselement; und/oder wobei das genannte Verstärkungselement ausgewählt ist aus folgenden Möglichkeiten: einem Verstärkungselement mit Kantenemission und einem Verstärkungselement mit Obertlächenemission.

3. Verfahren nach einem der Ansprüche 1 oder 2, wobei das genannte wellenlängenselektive Element (18) eine festliegende Zentralwellenlänge oder eine einstellbare Zentralwellenlänge hat.

4. Verfahren nach einem der vorhergehenden Ansprüche, wobei das genannte wellenlängenselektive Element (18) ein Bandpassfilter oder in Interferenzfilter oder ein Etalon aufweist.

5. Verfahren nach einem der vorhergehenden Ansprüche, wobei der genannte Resonator einen freien Spektralbereich hat, der durch die optische Weglänge des genannten Umlaufweges bestimmt ist, und wobei das genannte Verstärkungselement einen freien Spektralbereich hat, der durch die optische Weglänge des Verstärkungselementes bestimmt ist, und wobei der genannte freie Spektralbereich des Verstärkungselementes im wesentlichen ein ganzzahliges Vielfaches des genannten freien Spektralbereiches des Resonators ist.

6. Verfahren nach einem der vorhergehenden Ansprüche, wobei der Schritt des Ableitens des genannten Steuersignals aus dem genannten elektrischen Signal folgende Einzelschritte aufweist:
i) Emission eines Bruchteils des auf dem genannten Umlaufweg laufenden Wegs aus dem Resonator, um einen Referenzstrahl zu erhalten;
ii) Detektieren eines Bruchteils des genannten Referenzstrahls um ein Referenzsignal zu erhalten; und
iii) Ableiten des genannten Steuersignals aus dem genannten elektrischen Signal und dem genannten Referenzsignal.

7. Verfahren nach einem der vorhergehenden Ansprüche, wobei der Schritt des Ableitens des genannten Steuersignals aus dem genannten elektrischen Signal beinhaltet, dass das genannte Steuersignal im wesentlichen gleichgesetzt wird dem Verhältnis des genannten elektrischen Signals zum genannten Referenzsignal oder im wesentlichen gleich dem genannten elektrischen Signal.

8. Verfahren nach einem der vorhergehenden Ansprüche, wobei das genannte Verstärkungselement (12) elektrisch gepumpt ist und der genannte Parameter einen Strom enthält, der dem genannten Verstärkungselement zugeführt wird.

9. Verfahren nach einem der vorhergehenden Ansprüche, wobei der genannte Parameter die Temperatur des genannten Verstärkungselementes (12) enthält, oder einen Strom, mit dem ein elektrisch betriebener Phasenanpasser versorgt wird.

10. Verfahren nach einem der vorhergehenden Ansprüche, wobei der genannte Laser weiterhin folgendes aufweist: i) eine optische Bank, die mit dem genannten Verstärkungselement (12) verbunden ist, und ii) einen Umkehrspiegel (20), der mit der Bank verbunden ist, wobei der Umkehrspiegel ein Ende des Resonators darstellt und das Verstärkungselement ein anderes Ende des Resonators und wobei der genannte Parameter die Temperatur der Bank ist.

11. Verfahren nach einem der vorhergehenden Ansprüche, weiterhin folgende Schritte aufweisend:
g) Auswählen eines Betriebspumppegels, mit dem das genannte Verstärkungselement (12) versorgt wird;
h) Setzen eines Pumppegels, der an das genannte Verstärkungselement angelegt wird, auf einen zweiten Pegel, der wesentlich größer ist als der genannte Betriebspumppegel; und
i) Absenken eines an das genannte Verstärkungselement angelegten Pumppegels vom genannten zweiten Pegel auf den genannten Betriebspumppegel.

12. Verfahren nach Anspruch 1, weiterhin folgenden Schritt aufweisend: Steuerung der Temperatur des genannten Verstärkungselementes (12), um sicherzustellen, dass die Leistung des genannten optischen Strahls im wesentlichen auf einem vorgegebenen Wert bleibt; und/oder Führen von auf dem genannten Umlaufweg laufendem Licht durch ein Filter.

13. Verfahren nach Anspruch 12, wobei das genannte Filter eine feste Zentralwellenlänge oder eine einstellbare Zentralwellenlänge hat.

14. Laser mit externer Kavität und mit einem optischen Resonator, der einen umlaufenden Strahlungsweg aufweist, wobei der Resonator folgendes aufweist:
a) ein gepumptes Halbleiter-Verstärkungselement (12); und
b) ein Etalon oder ein anderes wellenlängenselektives Element (18), unter Abstand von dem genannten Verstärkungselement, wobei ein Teil des auf dem Umlaufweg laufenden Lichtes von dem genannten wellenlängenselektiven Element reflektiert wird und wobei der genannte reflektierte Teil einem Strahlungsweg folgt, der verschieden ist von dem genannten Umlaufweg;
und wobei der Laser weiterhin folgendes aufweist:
c) einen ersten Detektor (22), der einen Bruchteil des genannten reflektierten Teils des Lichtes empfängt und ein elektrisches Signal entsprechend dem genannten reflektierten Teil abgibt; und
d) eine Verarbeitungsschaltung, um ein Steuersignal aus dem genannten elektrischen Signal abzuleiten;
wobei ein Parameter des Lasers durch die genannte Verarbeitungsschaltung entsprechend dem genannten Steuersignal gesteuert wird, um einen einmodigen (monomode) Betrieb des Lasers zu erhalten, und wobei der genannte Parameter im wesentlichen so gesteuert wird, dass das genannte Steuersignal auf einem vorgegebenen, nicht-minimierten Wert gehalten wird, wodurch der genannte reflektierte Teil des Lichts eine nicht-minimierte Leistung hat.

15. Laser nach Anspruch 14, wobei das genannte Verstärkungselement (12) ausgewählt ist aus entweder einem elektrisch gepumpten Verstärkungselement oder einem optisch gepumpten Verstärkungselement, und/oder wobei das genannte Verstärkungselement ausgewählt ist aus entweder einem Verstärkungselement mit Kantenemission oder einem Verstärkungselement mit Oberflächenemission.

16. Laser gemäß Anspruch 14, wobei das genannte wellenlängenselektive Element (18) eine feste Zentralwellenlänge oder eine einstellbare Zentralwellenlänge hat.

17. Laser nach Anspruch 14, wobei das genannte wellenlängenselektive Element (18) ein Bandpassfilter oder ein anderes Interferenzfilter oder ein Etalon aufweist.

18. Laser nach einem der Ansprüche 14 bis 17, wobei das genannte wellenlängenselektive Element (18) ein Etalon ist und wobei das Etalon einen freien Spektralbereich hat, der durch die optische Weglänge des Etalons bestimmt ist, und wobei das genannte Verstärkungselement einen freien Spektralbereich hat, der durch seine optische Weglänge bestimmt ist, und wobei der freie Spektralbereich des Etalons im wesentlichen ein ganzzahliges Vielfaches des freien Spektralbereiches des genannten Verstärkungselementes ist.

19. Laser nach einem der Ansprüche 14 bis 18, mit weiterhin einem zweiten Detektor, der so angeordnet ist, dass er ein Bruchteil des auf dem genannten Umlaufweg laufenden Lichtes empfängt und ein Referenzsignal abgibt.

20. Laser nach einem der Ansprüche 14 bis 19, wobei das genannte, durch die Verarbeitungsschaltung bereitgestellte Steuersignal im wesentlichen das Verhältnis des genannte elektrischen Signals zum Referenzsignal ist oder im wesentlichen gleich dem genannten elektrischen Signal ist.

21. Laser nach einem der Ansprüche 14 bis 20, wobei das genannte Verstärkungselement (12) elektrisch gepumpt ist und der genannte Parameter einen Strom aufweist, der durch das genannte Verstärkungselement geschickt wird.

22. Laser nach einem der Ansprüche 14 bis 12, wobei der genannte Parameter die Temperatur des genannten Verstärkungselementes (12) oder einen Strom enthält, der durch einen elektrisch betriebenen Phasenanpasser geschickt wird.

23. Laser nach einem der Ansprüche 14 bis 22, wobei der Laser weiterhin folgendes aufweist: i) eine optische Bank, die mit dem genannten Verstärkungselement (12) fest verbunden ist, und ii) einen Rücklaufspiegel, der mit der Bank fest verbunden ist, wobei der Rücklaufspiegel ein Ende des Resonators darstellt und das Verstärkungselement ein anderes Ende des Resonators, und wobei der genannte Parameter die Temperatur der Bank ist.

24. Laser nach einem der Ansprüche 14 bis 23, wobei die genannte Verarbeitungsschaltung die Temperatur des genannten Verstärkungselementes (12) steuert, um sicherzustellen, dass die Leistung des genannten optischen Strahls im wesentlichen gleich einem vorbestimmten Wert bleibt.

25. Laser nach einem der Ansprüche 14 bis 24, weiterhin mit einem Filter mit festbleibender Zentralwellenlänge oder einem Filter mit einstellbarer Zentralwellenlänge oder mit einem im Resonator angeordneten Filter.

## Revendications

1. Procédé pour émettre un faisceau optique monomode à partir d'un laser à cavité externe comprenant un résonateur optique ayant un trajet aller-retour, le procédé comprenant les étapes consistant à .
a) amplifier la lumière se déplaçant sur ledit trajet aller-retour en faisant passer ladite lumière à travers un élément de gain à semi-conducteur pompé (12) ;
b) transmettre la lumière se déplaçant sur ledit trajet aller-retour à travers un étalon ou un autre élément de sélection de longueur d'onde (18) qui est espacé dudit élément de gain (12) ;
c) réfléchir une portion de la lumière se déplaçant sur ledit trajet aller-retour à partir dudit élément de sélection de longueur d'onde (18), dans lequel ladite portion réfléchie suit un trajet qui est distinct dudit trajet aller-retour ;
d) détecter une fraction de ladite portion réfléchie de lumière pour fournir un signal électrique;
e) dériver un signal de commande à partir dudit signal électrique ; et
f) commander un paramètre dudit laser en réponse au dit signal de commande pour assurer un fonctionnement monomode dudit laser,
dans lequel ledit paramètre est sensiblement commandé pour maintenir ledit signal de commande fixe à une valeur non minimale prédéterminée, moyennant quoi ladite portion réfléchie de la lumière a une puissance non minimale.

2. Procédé selon la revendication 1, dans lequel ledit élément de gain (12) est sélectionné parmi un élément de gain pompé électriquement et un élément de gain pompé optiquement ; et/ou ledit élément de gain est sélectionné parmi un élément de gain d'émission de bord et un élément de gain d'émission de surface.

3. Procédé selon la revendication 1 ou 2, dans lequel ledit élément de sélection de longueur d'onde (18) a une longueur d'onde centrale fixe ou une longueur d'onde centrale réglable.

4. Procédé selon l'une quelconque des revendications précédentes, dans lequel ledit élément de sélection de longueur d'onde (18) comprend un filtre passe-bande ou un autre filtre d'interférence, ou un étalon.

5. Procédé selon l'une quelconque des revendications précédentes, dans lequel ledit résonateur a une plage spectrale libre de résonateur qui est déterminée par la longueur optique dudit trajet aller-retour et ledit élément de gain a une plage spectrale libre d'élément de gain qui est déterminée par la longueur optique dudit élément de gain et dans lequel ladite plage spectrale libre d'élément de gain est sensiblement un nombre entier multiple de ladite plage spectrale libre de résonateur.

6. Procédé selon l'une quelconque des revendications précédentes, dans lequel l'étape consistant à dériver ledit signal de commande dudit signal électrique comprend les étapes consistant à :
i) émettre une fraction de lumière se déplaçant sur ledit trajet aller-retour à partir dudit résonateur pour fournir un faisceau de référence ;
ii) détecter une fraction dudit faisceau de référence pour fournir un signal de référence ; et
iii) dériver ledit signal de commande dudit signal électrique et dudit signal de référence.

7. Procédé selon l'une quelconque des revendications précédentes, dans lequel l'étape consistant à dériver ledit signal de commande dudit signal électrique comprend l'étape consistant à régler ledit signal de commande pour qu'il soit sensiblement égal à un rapport dudit signal électrique sur ledit signal de référence ou pour qu'il soit sensiblement égal au dit signal électrique.

8. Procédé selon l'une quelconque des revendications précédentes, dans lequel ledit élément de gain (12) est pompé électriquement, et ledit paramètre comprend un courant fourni au dit élément de gain.

9. Procédé selon l'une quelconque des revendications précédentes, dans lequel ledit paramètre comprend la température dudit élément de gain (12) ou un courant fourni à un ajusteur de phase commandé électriquement.

10. Procédé selon l'une quelconque des revendications précédentes, dans lequel ledit laser comprend en outre
i) un banc fixé sur ledit élément de gain (12), et ii) un miroir de retour (20) fixé sur le banc, le miroir de retour comprenant une extrémité dudit résonateur et l'élément de gain comprenant une autre extrémité dudit résonateur, et dans lequel ledit paramètre est la température du banc.

11. Procédé selon l'une quelconque des revendications précédentes, comprenant en outre les étapes consistant à :
g) sélectionner un niveau de pompage opérationnel fourni au dit élément de gain (12) ;
h) régler un niveau de pompage fourni au dit élément de gain à un second niveau qui est sensiblement supérieur au dit niveau de pompage opérationnel ; et
i) réduire un niveau de pompage fourni au dit élément de gain du second niveau au dit élément de pompage opérationnel.

12. Procédé selon la revendication 1, comprenant en outre l'étape consistant à commander la température dudit élément de gain (12) pour garantir que la puissance dudit faisceau optique reste sensiblement égale à une valeur prédéterminée ; et/ou transmettre la lumière se déplaçant sur ledit trajet aller-retour à travers un filtre.

13. Procédé selon la revendication 12, dans lequel ledit filtre a une longueur d'onde de centre fixe ou une longueur d'onde de centre réglable.

14. Laser à cavité externe comprenant un résonateur optique ayant un trajet aller-retour, dans lequel le résonateur comprend .
a) un élément de gain à semi-conducteur pompé (12) ; et
b) un étalon ou un autre élément de sélection de longueur d'onde (18) espacé dudit élément de gain, dans lequel une portion de la lumière se déplaçant sur ledit trajet aller-retour est réfléchie à partir dudit élément de sélection de longueur d'onde et dans lequel ladite portion réfléchie suit un trajet qui est distinct dudit trajet aller-retour ;
et dans lequel le laser comprend en outre :
c) un premier détecteur (22) qui reçoit une fraction de ladite portion de lumière réfléchie et fournit un signal électrique en réponse à ladite portion réfléchie ; et
d) une logique de traitement pour dériver un signal de commande dudit signal électrique ;
dans lequel un paramètre dudit laser est commandé par ladite logique de traitement en réponse au dit signal de contrôle pour assurer un fonctionnement monomode dudit laser et ledit paramètre est commandé sensiblement pour maintenir ledit signal de commande fixe à une valeur non minimale prédéterminée moyennant quoi ladite portion de lumière réfléchie a une puissance non minimale.

15. Laser selon la revendication 14, dans lequel ledit élément de gain (12) est sélectionné parmi un élément de gain pompé électriquement et un élément de gain pompé optiquement ; et/ou ledit élément de gain est sélectionné parmi un élément de gain d'émission de bord et un élément de gain d'émission de surface.

16. Laser selon la revendication 14, dans lequel ledit élément de sélection de longueur d'onde (18) a une longueur d'onde centrale fixe ou une longueur d'onde centrale réglable.

17. Laser selon la revendication 14, dans lequel ledit élément de sélection de longueur d'onde (18) comprend un filtre passe-bande ou un autre filtre d'interférence, ou un étalon.

18. Laser selon l'une quelconque des revendications 14 à 17, dans lequel ledit élément de ,sélection de longueur d'onde (18) est un étalon et dans lequel ledit étalon a une plage spectrale libre d'étalon déterminée par la longueur optique dudit étalon, et ledit élément de gain a une plage spectrale libre d'élément de gain déterminée par la longueur optique dudit élément de gain, et dans lequel ladite plage spectrale libre d'étalon est sensiblement un nombre entier multiple de ladite plage spectrale libre d'élément de gain.

19. Laser selon l'une quelconque des revendications 14 à 18, comprenant en outre un second détecteur positionné pour recevoir une fraction de lumière se déplaçant sur ledit trajet aller-retour et fournir un signal de référence.

20. Laser selon l'une quelconque des revendications 14 à 19, dans lequel ledit signal de commande fourni par ladite logique de traitement est sensiblement un rapport dudit signal électrique sur ledit signal de référence, ou est sensiblement égal au dit signal électrique.

21. Laser selon l'une quelconque des revendications 14 à 20, dans lequel ledit élément de gain (12) est pompé électriquement, et ledit paramètre comprend un courant fourni au dit élément de gain.

22. Laser selon l'une quelconque des revendications 14 à 21, dans lequel ledit paramètre comprend la température dudit élément de gain (12) ou un courant fourni à un ajusteur de phase commandé électriquement.

23. Laser selon l'une quelconque des revendications 14 à 22, dans lequel ledit laser comprend en outre i) un banc fixé au dit élément de gain (12), et ii) un miroir de retour fixé sur le banc, le miroir de retour comprenant une extrémité dudit résonateur et l'élément de gain comprenant une autre extrémité dudit résonateur, et dans lequel ledit paramètre est la température du banc.

24. Laser selon l'une quelconque des revendications 14 à 23, dans lequel ladite logique de traitement commande la température dudit élément de gain (12) pour garantir que la puissance dudit faisceau optique reste sensiblement égale à une valeur prédéterminée.

25. Laser selon l'une quelconque des revendications 14 à 24, comprenant en outre un filtre de longueur d'onde centrale fixe ou un filtre de longueur d'onde centrale réglable ou un autre filtre positionné à l'intérieur dudit résonateur.
